# EUROPEAN PATENT SPECIFICATION

(11) **EP 0 608 090 B1**
(45) Date of publication and mention of the grant of the patent: **12.07.2000**
(21) Application number: 94300292.3
(22) Date of filing: 17.01.1994
(51) Int. Cl.: G02F 1/136, H01L 27/12

(54) **Semiconductor device which can be applied to liquid crystal display apparatus and method of manufacturing such a semiconductor device**
Halbleitervorrichtung zur Anwendung in Flüssigkristall-Anzeigevorrichtungen und Verfahren zu ihrer Herstellung
Dispositif à semi-conducteur, applicable à un dispositif d'affichage à cristal liquide et son procédé de fabrication

(30) Priority: 18.01.1993 JP 2163993
(43) Date of publication of application: 27.07.1994
(73) Proprietor: CANON KABUSHIKI KAISHA, Tokyo (JP)
(72) Inventor: Kohchi, Tetsunobu, c/o Canon Kabushiki Kaisha, Ohta-ku, Tokyo (JP); Miyawaki, Mamoru, c/o Canon Kabushiki Kaisha, Ohta-ku, Tokyo (JP)
(74) Representative: Beresford, Keith Denis Lewis

(56) References cited:
- EP-A- 0 474 474
- PATENT ABSTRACTS OF JAPAN vol. 13, no. 57 (P-825) 9 February 1989 & JP-A-63 246 728 (RICOH) 13 October 1988
- PATENT ABSTRACTS OF JAPAN vol. 15, no. 262 (P-1222) 3 July 1991 & JP-A-03 085 530 (SHARP) 10 April 1991
- PATENT ABSTRACTS OF JAPAN vol. 17, no. 122 (P-1501) 15 March 1993 & JP-A-04 305 625 (SONY) 28 October 1992

## Description

### BACKGROUND OF THE INVENTION

### Field of the Invention

The present invention relates to a semiconductor device in which a passive element and an active element are provided on a semiconductor layer formed on an insulating layer or an insulating substrate. The invention also relates to a liquid crystal display apparatus in which a liquid crystal layer is sandwiched between a substrate on which the semiconductor device is formed and a transparent substrate.

### Related Background Art

A semiconductor device in which a semiconductor layer is formed on an insulating layer or an insulating substrate and a passive element and an active element are formed on the surface of the semiconductor layer is generally called an SOI (Silicon on Insulator) device. Such devices are considered important because high speeds and a high degree of integration can be realized because of the following two reasons.
(1) In a transistor with an SOI structure, the circuit can be easily made fine, the current driving ability is high, and the transistor is excellent in high speed operation.
(2) Wiring can be provided on the insulating substrate, capacity is lower than in conventional devices,
   and high speed and a high integration degree can be achieved.

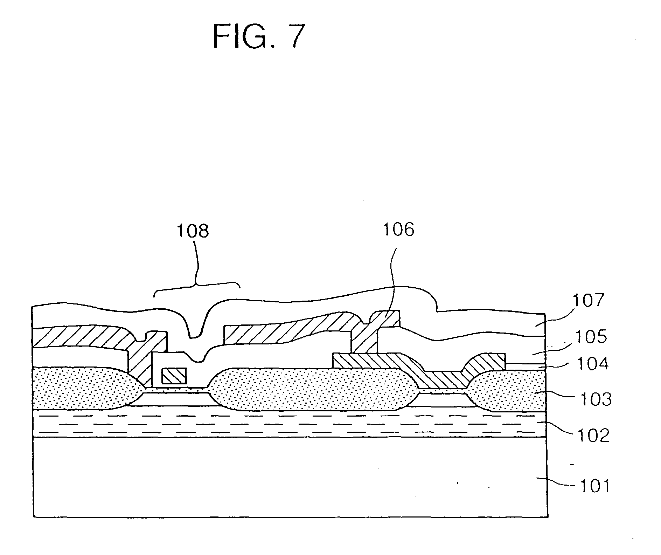

To realise high speed and integration degree, a multi-layer wiring is essential as shown in Fig. 7 which is a cross sectional view of a conventional semiconductor device. In Fig. 7, reference numeral 101 denotes an Si substrate; 102 an insulating layer (Si0₂); 103 a field oxide layer; 104 a poly silicon (Si) wiring; 105 an inter-layer insulating layer; 106 an Al wiring; and 107 an insulating layer.

However, as shown by reference numeral 108, there are significant variations in the height of the wiring portion, and as a result, snapping of a wire in the raised portion and defective patterning of the wiring layer become problems. To avoid these problems, it is required to perform a smoothing process after the formation of the wiring.

However, when the smoothing process is executed, the following problems occur:
(1) The addition of a new step causes manufacturing costs to rise.
(2) The provision of a smoothing layer increases the distance between the wirings and the overall thickness of the device increases. The contact region between the lower wiring and the upper wiring increases. The chip size increases.

Further, the liquid crystal display apparatus has the following problems.

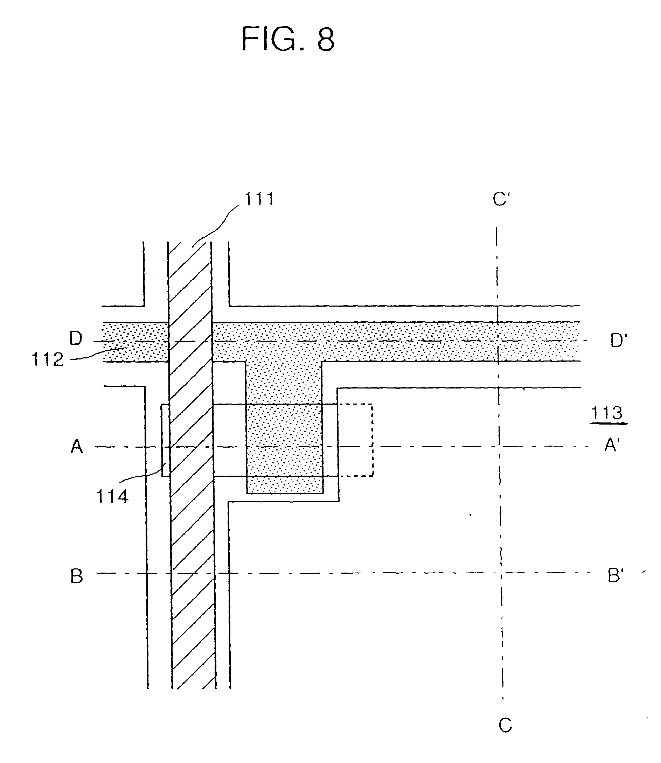

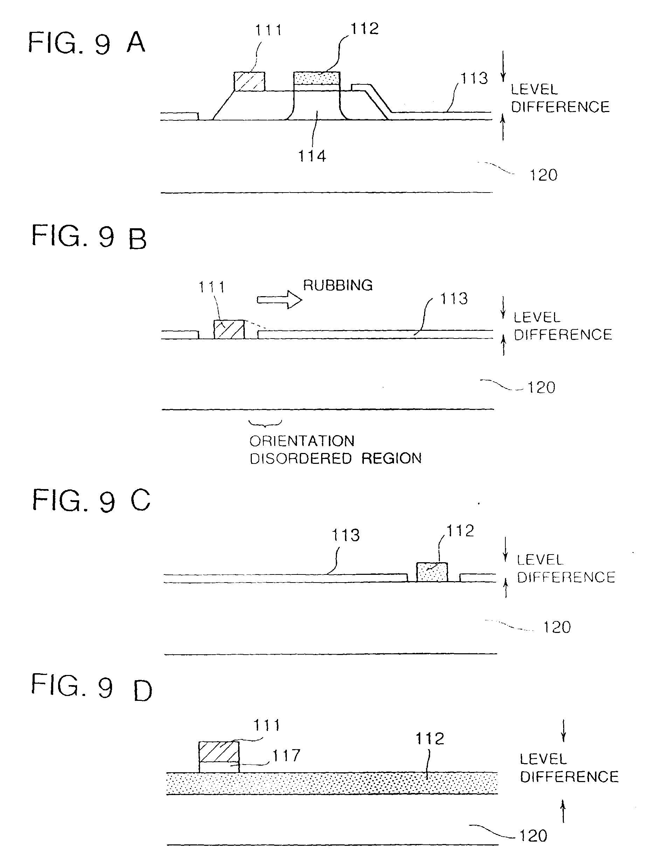

Fig. 8 shows a plan view of an array substrate of the conventional liquid crystal display apparatus. Figs. 9A to 9D show cross sectional views of Fig. 8. Fig. 9A is a cross sectional view taken along the line A-A' in fig. 8. Fig. 9B is a cross sectional view taken along the line B-B' in fig. 8. Fig. 9C is a cross sectional view taken along the line C-C' in Fig. 8. Fig. 9D is a cross sectional view taken along the line D-D' in Fig. 8. In Figs. 8 and 9A to 9D, reference numeral 111 denotes a data line; 112 an address line; 113 a pixel electrode; 114 a semiconductor layer; 117 an insulating layer; and 120 a substrate.

Hitherto, the surface of the array substrate has a structure with large height differences (0.5 to 1.0 µm, as shown in Figs. 9A to 9C. Particularly, the intersection point between the data line 111 and the address line 112 shown in Fig. 9D indicates a portion in the pixel which projects the most. Therefore, at the time of rubbing, an orientation disturbance occurs at a position near the projecting portion, a white blank region in which transmittance is not changed by an applied voltage occurs, and the contrast is deteriorated.

To solve the above problems, a method of light shielding the white blank region is considered. However, this method also results in the brightness being reduced by the amount of light shield, making this solution undesirable. No effective means for solving the above problems exists. Therefore, at present, the situation is that the film thicknesses of the data line 111 and address line 112 are made thin and the height difference is set to a value within an error range and the orientation variation which results from the height difference is substantially ignored.

It is a concern of the invention to provide a semiconductor device and a liquid crystal display apparatus which can solve the problems as mentioned above.

Another concern of the invention is to provide a semiconductor device having a flat surface which is accompanied with none of the enlargement of the chip size, increase in costs, disconnection of wires, and defective wiring pattern.

JP-A-63-246728 discloses a liquid crystal active matrix panel in which the cross over of data lines and address lines is eliminated.

EP-A-0474474 discloses a liquid crystal display device in which the circuit elements of drive circuits of the device are formed from a semiconductor single crystal thin film. The single crystal thin film and an insulating substrate are initially formed as a composite substrate. The circuit elements of the drive circuits are then formed by treating the single crystal thin film.

JP-A-3-085530 discloses a liquid crystal display device in which data lines and address lines have a two layered structure which is formed in a groove in an insulating layer.

JP-A-4-305625 discloses a liquid crystal display device which is manufactured by forming grooves on an insulating substrate and then forming data lines and address lines in the grooves.

In accordance with a first aspect of the present invention there is provided a liquid crystal display device as set out in claim 1.

In accordance with a second aspect of the present invention there is provided a method of manufacturing an array substrate for a liquid crystal display device as set out in claim 3.

### BRIEF DESCRIPTION OF THE DRAWINGS

Fig. 1 is a cross sectional view showing a recessed wiring structure;
Figs. 2A to 2C are diagrams showing a method of manufacturing the recessed wiring structure of Fig. 1;
Fig. 3 is a cross sectional view showing a further recessed wiring structure;
Fig. 4 is a cross sectional view showing a further recessed wiring structure;
Fig. 5 is a plan view showing an array substrate of a liquid crystal display apparatus of an embodiment of the invention;
Figs. 6A to 6C are cross sectional views of Fig. 5;
Fig. 7 is a cross sectional view showing a conventional semiconductor device;
Fig. 8 is a plan view showing an array substrate of a conventional liquid crystal display apparatus; and
Figs. 9A to 9D are cross sectional views of Fig. 8.

Prior to describing an embodiment of the present invention, a number of recessed wiring structures and methods of manufacturing such structures will be described.

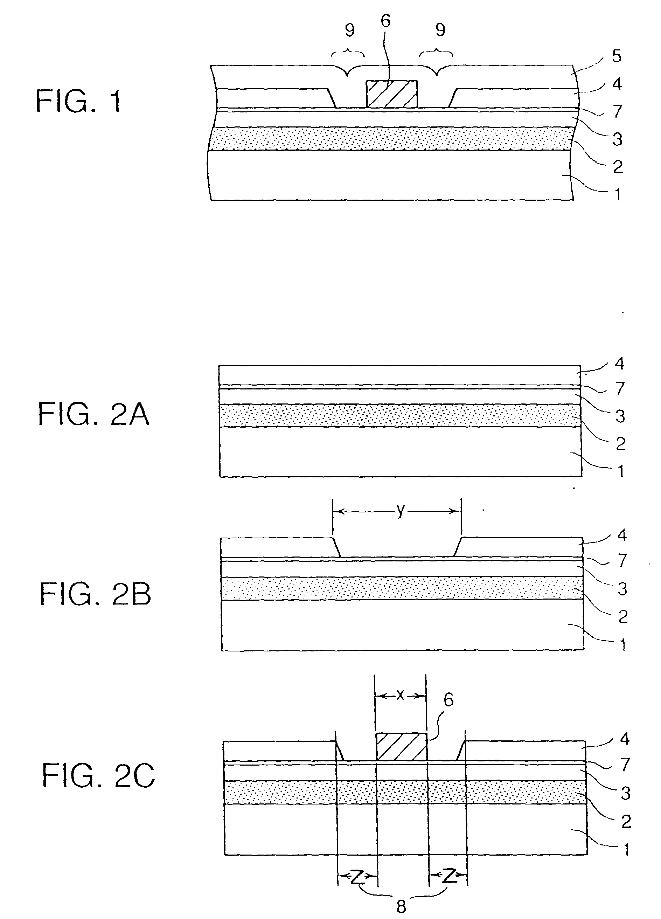

Referring now to the accompanying drawings, Fig. 1 shows an example of a recessed wiring structure. Figs. 2A to 2C show a method of manufacturing of the wiring structure of Fig. 1. In Figs. 1 and 2A to 2C, reference numeral 1 denotes a semiconductor substrate such as Si, GaAs, or the like or an insulating substrate such as glass, sapphire, or the like; 2 an insulating layer of, for example, SiO₂, SiN, or an SiON layer as a compound thereof, or the like; 3 a first insulating layer; 7 a second insulating layer; 4 a third insulating layer; 5 a fourth insulating layer; and 6 a wiring layer. A semiconductor layer exists on another cross sectional surface.

In this example, the third insulating layer 4 is etched, thereby forming a recess. The second insulating layer 7 and the third insulating layer 4 are made by different materials, thereby allowing the second insulating layer 7 to function as a stopper upon etching of the third insulating layer 4. specifically speaking, it is sufficient to use a film of the SiO₂ system as a material of the third insulating layer 4 and to use a film of the SiN system as a material of the second insulating layer 7. It is sufficient to use the HF system as an etchant. It will be obviously understood that the etching method is not limited to the wet etching but a dry etching can be also performed.

The relation between the width y of the recess and the width x of wiring will now be described. As shown in figs. 2B and 2C, the values of x and y are set so as to satisfy the following relation:$\text{y > x}$ A gap Z between the concave portion and the wiring portion 6 is determined by the film forming condition of the fourth insulating layer 5 after completion of the wiring step and the precision of the gap Z. A film can then be formed onto the height different portion by a CVD. By deciding the gap amount Z to be a value that is about two times as large as the depth of the recess, an almost flat insulating layer 5 can be formed on the wiring as shown at reference numeral 9 in fig. 1. The value of x can be varied to (x + Δx) so that a flat layer can be stably formed. By this method shown the desired flat layer can be easily realized.

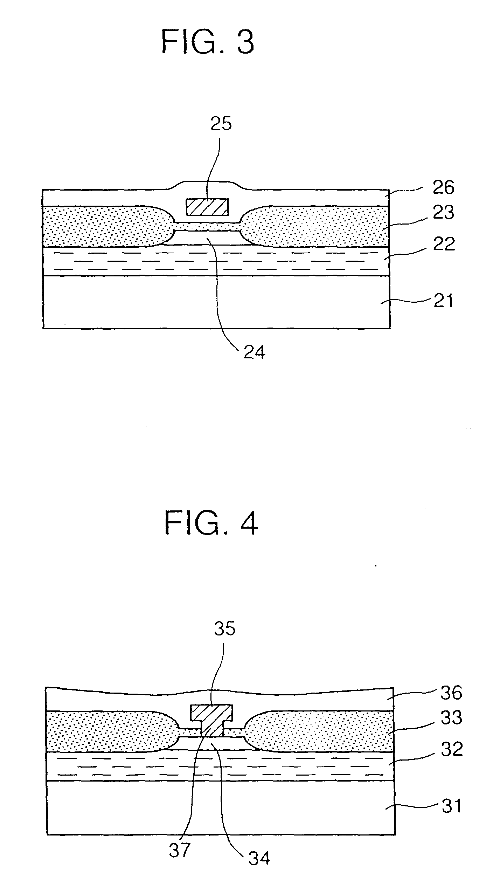

A further example of a recessed wiring structure will now be described with reference to Fig. 3. In Fig. 3 reference numeral 21 denotes a substrate. For example, a semiconductor substrate made of Si, GaAs, or the like or an insulating substrate made by glass, sapphire, or the like is used as a substrate 21. Reference numeral 22 denotes an insulating layer formed on the substrate 21. For example, SiO₂, SiN, or an SiON film as a compound thereof, or the like is used as an insulating layer 22. Reference numeral 23 denotes a field oxide film; 24 a semiconductor layer made of Si or the like; 25 a wiring; and 26 an inter-layer insulating layer. Although not shown, a wiring layer of multi-layers can be also formed on the upper layer of the inter-layer insulating layer 26.

In the example, a recess is formed by using the semiconductor layer 24. The resess can be formed by a selective oxidation process or the like such that a part of the semiconductor layer 24 is covered by, for example, an SiN film or the like and a region which is not covered is selectively oxidized by a heat and the field oxide film 23 is formed. As shown in Fig. 3, since the wiring 25 is formed over the semiconductor layer 24 as an active region, the upper portion of the wiring layer 25 is not projected and a flat surface can be realized by the inter-layer insulating layer 26. By floating the potential of the semiconductor layer 24, a parasitic capacitance is not caused between the wiring layer 25 and the semiconductor layer 24, and a wiring of a low capacitance can be realised.

A further example of a recessed wiring structure will now be described with reference to Fig. 4. In a manner similar to the second example, reference numeral 31 denotes a substrate; 32 an insulating layer; 33 a field oxide film; 34 a semiconductor layer; 35 a wiring; 36 an inter-layer insulating layer or upper portion insulating layer; and 37 a contact between the semiconductor layer 34 and the wiring 35.

In this example, a recess is formed by using the semiconductor layer 34 in a manner similar to the second example. It is a feature of the present example that a part of the wiring 35 is brought into contact with the semiconductor layer 34 and so that the semiconductor layer 34 may also be used as a wiring. With such a construction, not only is the upper surface flattened but also the wiring resistance is reduced, redundancy of the wiring 35 also increases and yield rises. In case of cross wiring by using the same wiring material with the above structure, although a poly Si wiring is generally used, by using the present method it is possible to jump by a monocrystalline layer and a flat cross wiring can be performed with a low resistance without increasing the wiring layer than the ordinary one.

It will be obviously understood that in order to realise enough contact 37 with the upper wiring 35, a semiconductor layer 34.

Wirings in which the wiring 25 on a floating region semiconductor layer in the second example and the wiring 35 which is in contact with the lower semiconductor layer 34 of the third example exist together are also effective. In this case, it is sufficient that the semiconductor layers are separated by an insulating layer.

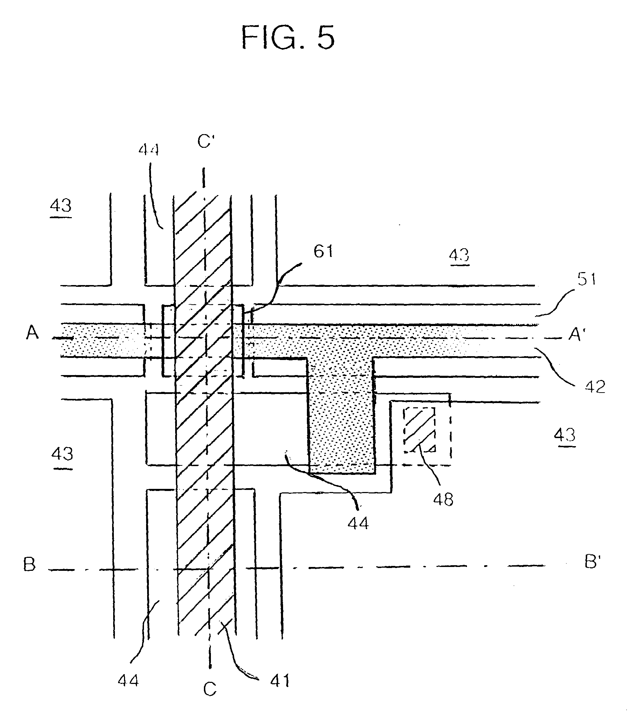

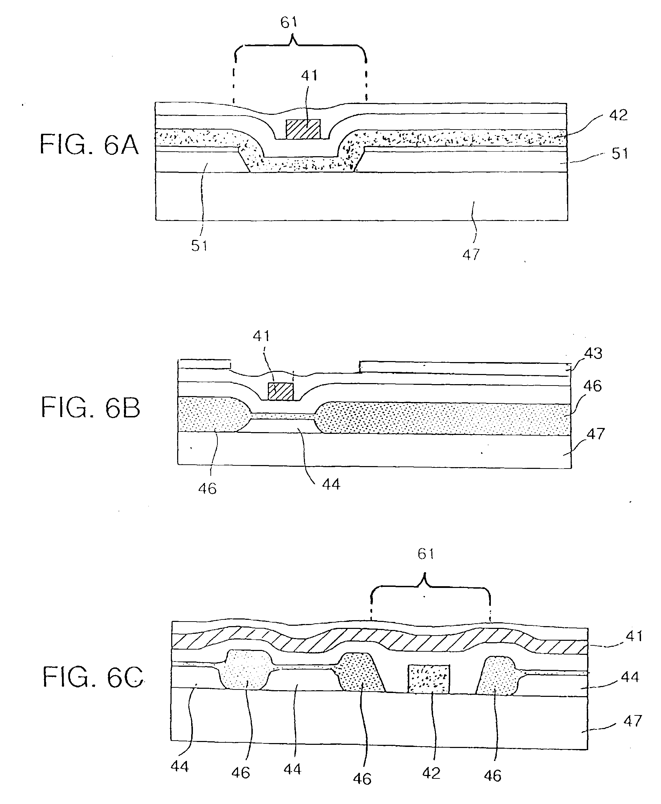

Fig. 5 is a plan view of an array substrate of a liquid crystal display apparatus of an embodiment of the present invention. Figs. 6A to 6C are cross sectional views of fig. 5. Fig. 6A is a cross sectional view taken along the line A-A' in fig. 5, Fig. 6B is a cross sectional view taken along the line B-B', and Fig. 6C is a cross sectional view taken along the line C-C'. In Figs. 5 and 6A to 6C, reference numeral 41 denotes a data line; 42 an address line; 43 a pixel electrode; 44 an active layer; 46 a field oxide film; 47 a transparent substrate; 48 an electrode for connecting a drain of a TFT and the pixel electrode 43; and 51 another active layer.

As can be seen in Figs. 6B and 6C the field oxide film 46 is reduced in thickness above the active layer 44. In this way a recess is provide above the active layer 44 in which the wiring layer of the data line 41 is formed. The wiring layer of the data line 41 does not then protrude above the surface of the pixel electrode 43 and hence when the surface of the pixel electrode 43 is rubbed the orientation disturbance resulting from the protrusion of the data line 41 is minimised.

Similarly a recess is also provided above the active layer 51 in which the wiring layer of the data line 42 is formed. Thus in these regions the height by which the wiring layer of the data line 42 protrudes above the surface of the pixel electrode 43 is also minimised.

In Figs. 5, 6A and 6C reference numeral 61 denotes a recess in the region in which the data line 41 and the address line 42 intersect. It is a feature of the present invention that the recess 61 in the region in which the data line 41 and the address line 42 intersect is deeper than the recesses formed above active regions layers 44 and 51. Hitherto, when the data line 41 and the address line 42 intersect, such an intersection portion is the highest and orientation characteristics of the liquid crystal are disordered. However, by using the structure of the method of the present invention, an almost flat structure can be realised.

In the embodiment, although the data line 41 over the active layer 44 is separated by the insulating layer, as shown in the third example of a recessed wiring structure, it will be also obviously understood that the data line may be brought into contact with the active layer 44.

As a method of forming the recesses of different depths, there s a method whereby a field oxide layer above an active layer region is etched away to provide a shallow recess and a portion of the active layer itself is etched away to provide a deep recess. It will be obviously understood that the invention is not limited to such a method but a method of changing the depth by performing the etching process a number of times can be also used and that by partially arranging the etching stop layers, the recesses of different depths can be formed.

As described above, a semiconductor device having a flat surface can be obtained without performing any special flattening process and it is possible to prevent the enlargement of the chip size, increase in costs, disconnection, and defective wiring pattern.

Further, by using the array substrate on which such a semiconductor device is formed, it is possible to realise a liquid crystal display apparatus in which the orientation variation upon rubbing decreases, so that a white blank degree of the pixel portion is small and a high contrast ratio is obtained.

## Claims

1. A liquid crystal display device comprising:
a substrate (47) having deposited, thereon a multilayered structure comprising an insulating layer (46) and active layers (44,51);
an array of pixel electrodes (43) each having associated a switch element;
a plurality of address lines (41) and a plurality of data lines (42), said address lines (41) and data lines (42) being arranged so a to intersect and being provided in respective intersecting recesses formed in said multilayered structure, wherein each switch element of said array of pixel electrodes (43) is connected to one of said plurality of address lines (41) and one of said plurality of data lines (42), characterised in that
a deeper recess (61) is provided in one of said active layers (44) at each intersection of said address lines (41) and data lines (42) whereby the extent by which said intersections of address lines (41) and data lines (42) protrudes with respect to the surface of said array of pixel electrodes (43) is reduced.

2. A liquid crystal display device in accordance with claim 1, wherein the depth of said intersecting recesses is almost equal to the thickness of said data line or said address line.

3. A method of manufacturing an array substrate for a liquid crystal display device comprising the steps of:
forming a multilayered structure comprising an insulating layer (46) and active layers (44,51) on a substrate (47);
forming a plurality of intersecting recesses in said multilayered structure (44,51);
forming a plurality of address lines (41) and a plurality of data lines (42), said address lines (41) and data lines (42) in said plurality of intersecting recesses in said multilayered structure;
forming an array of pixel electrodes (43) each having a switch element, wherein each switch element of said array of pixel electrodes (43) is connected to one of said plurality of address lines (41) and one of said plurality of data lines (42), characterised by:
providing a deeper recess (61) in one of said active layers (44) at each intersection of said address lines (41) and data lines (42).

4. A method according to claim 3, wherein said recesses are formed by etching.

5. A method according to claim 3, wherein said intersecting recesses are formed by selective oxidation of a semiconductor layer.

## Patentansprüche

1. Flüssigkristallanzeigevorrichtung mit
einem Substrat (47) mit einem darauf abgeschiedenen vielschichtigen Aufbau mit einer isolierenden Schicht (46) und aktive Schichten (44, 51);
einer regelmäßigen Anordnungen von Bildelementelektroden (43) mit jeweils einem angegliederten Schaltelement;
einer Vielzahl von Adressleitungen (41) und einer Vielzahl von Datenleitungen (42), dabei sind die Adressleitungen (41) und die Datenleitungen (42) so angeordnet, dass sie sich überkreuzen und in entsprechenden in dem vielschichtigen Aufbau ausgebildeten Kreuzungsvertiefungen bereitgestellt sind, wobei jedes Schaltelement der regelmäßigen Anordnung von Bildelementelektroden (43) mit einer aus der Vielzahl von Adressleitungen (41) und einer aus der Vielzahl von Datenleitungen (42) verbunden ist,
**dadurch gekennzeichnet, daß**
eine tiefere Vertiefung (61) in einer der aktiven Schichten (44) bei jeder Kreuzung der Adressleitungen (41) und Datenleitungen (42) bereitgestellt ist, wodurch das Ausmaß, um das die Kreuzungen der Adressleitungen (41) und der Datenleitungen (42) bezüglich der Oberfläche der regelmäßigen Anordnung von Bildelementelektroden (43) hervorstehen, verringert wird.

2. Flüssigkristallanzeigevorrichtung nach Anspruch 1, wobei die Tiefe der Kreuzungsvertiefungen nahezu gleich der Dicke der Datenleitung oder der Adressleitung ist.

3. Verfahren zur Herstellung eines Substrates für eine regelmäßigen Anordnung für eine Flüssigkristallanzeigevorrichtung mit den Schritten
Ausbilden eines vielschichtigen Aufbaus mit einer isolierenden Schicht (46) und aktiven Schichten (44, 51) auf einem Substrat (47);
Ausbilden einer Vielzahl von Kreuzungsvertiefungen in dem vielschichtigen Aufbau (44, 51);
Ausbilden einer Vielzahl von Adressleitungen (41) und einer Vielzahl von Datenleitungen (42), die Adressleitungen (41) und Datenleitungen (42) in der Vielzahl von Kreuzungsvertiefungen in dem vielschichtigen Aufbau;
Ausbilden einer regelmäßigen Anordnung von Bildelementelektroden (43) mit jeweils einem Schaltelement, wobei jedes Schaltelement der regelmäßigen Anordnung von Bildelementelektroden (43) mit einer aus der Vielzahl von Adressleitungen (41) und einer aus der Vielzahl von Datenleitungen (42) verbunden ist,
**gekennzeichnet durch**
das Bereitstellen einer tieferen Vertiefung (61) in einem der aktiven Schichten (44) bei jeder Kreuzung von Adressleitungen (41) und Datenleitungen (42).

4. Verfahren nach Anspruch 3, wobei die Vertiefungen durch Ätzen ausgebildet werden.

5. Verfahren nach Anspruch 3, wobei die Kreuzungsvertiefungen durch selektive Oxidation einer Halbleiterschicht ausgebildet werden.

## Revendications

1. Dispositif d'affichage à cristal liquide comportant : un substrat (47) sur lequel est déposée une structure multicouche comprenant une couche isolante (46) et des couches actives (44, 51) ;
un groupement d'électrodes (43) de pixels ayant chacune un élément de commutation associé ;
une pluralité de lignes d'adresses (41) et une pluralité de lignes de données (42), lesdites lignes d'adresses (41) et lesdites lignes de données (42) étant agencées de façon à se croiser et étant prévues dans des évidements respectifs se croisant formés dans ladite structure multicouche, chaque élément de commutation dudit groupement d'électrodes (43) de pixels étant connecté à l'une de ladite pluralité de lignes d'adresses (41) et à l'une de ladite pluralité de lignes de données (42),
caractérisé en ce que
un évidement plus profond (61) est prévu dans l'une desdites couches actives (44) à chaque croisement desdites lignes d'adresses (41) et desdites lignes de données (42), grâce à quoi l'étendue sur laquelle lesdits croisements de lignes d'adresses (41) et de lignes de données (42) font saillie par rapport à la surface dudit groupement d'électrodes (43) de pixels est réduite.

2. Dispositif d'affichage à cristal liquide selon la revendication 1, dans lequel la profondeur desdits évidements se croisant est presque égale à l'épaisseur de ladite ligne de données ou de ladite ligne d'adresse.

3. Procédé de fabrication d'un substrat de groupement pour un dispositif d'affichage à cristal liquide, comprenant les étapes dans lesquelles :
on forme une structure multicouche comprenant une couche isolante (46) et des couches actives (44, 51) sur un substrat (47) ;
on forme une pluralité d'évidements se croisant dans ladite structure multicouche (44, 51) ;
on forme une pluralité de lignes d'adresses (41) et une pluralité de lignes de données (42), lesdites lignes d'adresses (41) et lesdites lignes de données (42) dans ladite pluralité d'évidements se croisant dans ladite structure multicouche ;
on forme un groupement d'électrodes (43) de pixels ayant chacune un élément de commutation, chaque élément de commutation dudit groupement d'électrodes (43) de pixels étant connecté à l'une de ladite pluralité de lignes d'adresses (41) et l'une de ladite pluralité de lignes de données (42), caractérisé par :
la présence d'un évidement plus profond (61) dans l'une desdites couches actives (44) à chaque croisement desdites lignes d'adresses (41) et desdites lignes de données (42).

4. Procédé selon la revendication 3, dans lequel lesdits évidements sont formés par attaque chimique.

5. Procédé selon la revendication 3, dans lequel lesdits évidements se croisant sont formés par une oxydation sélective d'une couche de semiconducteur.
